# EUROPEAN PATENT SPECIFICATION

(11) **EP 2 802 006 B1**
(45) Date of publication and mention of the grant of the patent: **25.10.2017**
(21) Application number: 14157586.0
(22) Date of filing: 04.03.2014
(51) Int. Cl.: H01L 23/367, H01L 23/42, G06F 1/20

(54) **Vehicle-mounted radio network access device**
Fahrzeugmontierte Funknetzzugangsvorrichtung
Dispositif d'accès au réseau radio monté sur un véhicule

(30) Priority: 07.05.2013 CN 201310163379
(43) Date of publication of application: 12.11.2014
(73) Proprietor: Huawei Device Co., Ltd., Longgang District Shenzhen Guangdong 518129 (CN)
(72) Inventor: Zhang, Kecheng, 518129 Shenzhen (CN); Wu, Jianguang, 518129 Shenzhen (CN); Sun, Lue, 518129 Shenzhen (CN)
(74) Representative: Gill Jennings & Every LLP

(56) References cited:
- EP-A1- 2 075 993
- US-A1- 2002 149 913
- US-A1- 2012 307 453
- US-A1- 2013 050 953
- "3M Electronics Assembly Solutions Product Selection Guide Solutions Value Smart for Building In", , 13 January 2012 (2012-01-13), XP055220533, Retrieved from the Internet: URL:http://www.mouser.com/pdfdocs/3M-Elect ronic-Assembly-Solutions-Guide.pdf [retrieved on 2015-10-13]

## Description

### TECHNICAL FIELD

The present invention relates to the field of communications, and in particular, to a vehicle-mounted wireless Internet access device.

### BACKGROUND

With the development of communication technologies, communication products are more and more diversified. A vehicle-mounted wireless Internet access device is a vehicle-mounted infotainment product installed in a vehicle. The vehicle-mounted radio network access device should be capable of implementing information communication between a person and the vehicle and between the vehicle and the outside world (between vehicles). With the constant development of the vehicle-mounted radio network access device, an issue on cooling the vehicle-mounted wireless Internet access device has attracted wide attention. Currently, the vehicle-mounted wireless Internet access device implements cooling through cross ventilation by opening a cooling hole on an enclosure. However, opening a cooling hole on the enclosure cannot implement a waterproof function of the vehicle-mounted wireless Internet access device.

EP 2075993, US 2013/050953 and US 2012/307453 all disclose techniques for controlling heat dissipation in electronic devices.

A vehicle-mounted wireless Internet access device is provided to implement cooling and meanwhile implement a waterproof function.

According to a first aspect, there is provided a vehicle-mounted wireless internet access device, comprising a sealed enclosure, a heating element, and a first thermal pad, wherein the heating element and the first thermal pad are arranged inside the sealed enclosure; the top of the sealed enclosure comprises a metal part, and the first thermal pad is arranged between the heating element and the metal part of the sealed enclosure to transfer heat produced by the heating element to the metal part, so that the heating element is cooled; a heat sink, wherein the heat sink is arranged between the first thermal pad and the metal part of the sealed enclosure to absorb the heat transferred by the first thermal pad, so that the heat is transferred to the metal part after the heat is dissipated evenly, and further comprising a second thermal pad, wherein the second thermal pad is arranged between the heat sink and the metal part of the sealed enclosure to transfer the heat on the heat sink to the metal part.

The vehicle-mounted wireless Internet access device further includes a heat sink, where the heat sink is arranged between the first thermal pad and the metal part of the sealed enclosure to absorb the heat transferred by the first thermal pad, so that the heat is transferred to the metal part after the heat is dissipated evenly.

The vehicle-mounted wireless Internet
access device further includes a second thermal pad, where the second thermal pad is arranged between the heat sink and the metal part of the sealed enclosure to transfer the heat on the heat sink to the metal part. In a possible implementation, the first thermal pad and the second thermal pad use a silicone gel material and the heat sink uses a metal material.

In a possible implementation, the second thermal pad includes an adhesive surface and the second thermal pad is stuck to the heat sink through the adhesive surface. In a possible implementation, the first thermal pad includes an adhesive surface and the first thermal pad is stuck to the heating element through the adhesive surface.

In a possible implementation, the vehicle-mounted wireless Internet access device further includes an antenna, where the antenna is arranged inside the sealed enclosure and the top of the sealed enclosure includes a non-shielded material part, where the non-shielded material part corresponds to the antenna, so that signals of the antenna are radiated out.

In a possible implementation, the non-shielded material part is a plastic material part.

According to the vehicle-mounted wireless Internet access device provided by each of the foregoing implementation manners, the vehicle-mounted wireless Internet access device includes the sealed enclosure. The heating element and the first thermal pad are arranged inside the sealed enclosure. The top of the sealed enclosure includes the metal part. The first thermal pad is arranged between the heating element and the metal part of the sealed enclosure to transfer the heat produced by the heating element to the metal part, so that the heating element is cooled. The vehicle-mounted wireless Internet access device does not need to open a cooling port to perform cooling, but transfers, by using the first thermal pad inside the sealed enclosure, the heat produced by the heating element to the metal part of the sealed enclosure to implement a cooling function. Therefore, the vehicle-mounted wireless Internet access device in the present invention not only achieves a cooling purpose, but also implements a waterproof function.

### BRIEF DESCRIPTION OF DRAWING(S)

To describe the technical solutions in the embodiments of the present invention or in the prior art more clearly, the following briefly introduces the accompanying drawings required for describing the embodiments or the prior art. Apparently, the accompanying drawings in the following description show merely some embodiments of the present invention, and a person of ordinary skill in the art may still derive other drawings from these accompanying drawings without creative efforts.
FIG. 1 is a schematic diagram of a vehicle-mounted radio network access device;
FIG. 2 is a schematic diagram of a vertical section in FIG. 1;
FIG. 3 is a schematic diagram of a vertical section of a vehicle-mounted radio network access device and
FIG. 4 is a schematic diagram of a vertical section of a vehicle-mounted radio network access device according to the present invention.

### DESCRIPTION OF EMBODIMENTS

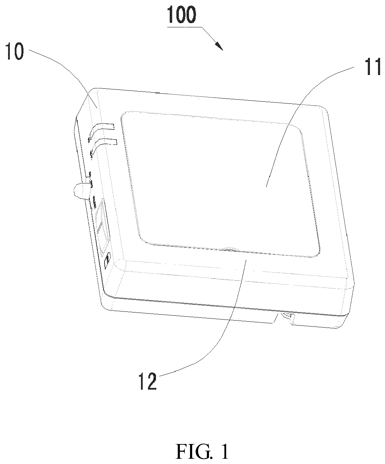

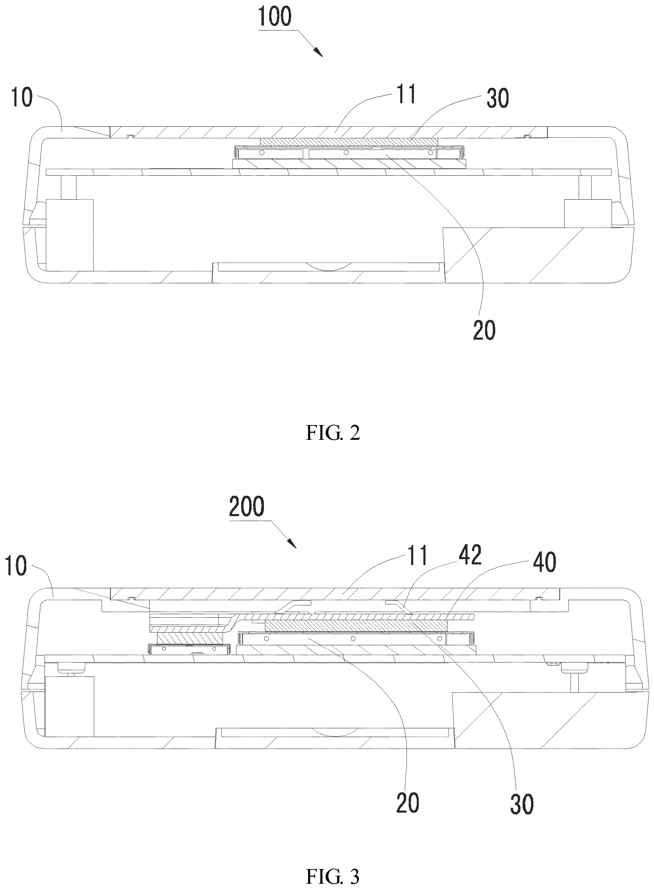

Referring to FIG. 1 and FIG. 2, a vehicle-mounted radio network access device 100 is provided. The vehicle-mounted wireless Internet access device 100 includes a sealed enclosure 10, a heating element 20, and a first thermal pad 30. The heating element 20 and the first thermal pad 30 are arranged inside the sealed enclosure 10. The top of the sealed enclosure 10 includes a metal part 11. The first thermal pad 30 is arranged between the heating element 20 and the metal part 11 of the sealed enclosure 10 to transfer the heat produced by the heating element 20 to the metal part 11, so that the heating element 20 is cooled.

Specifically, the first thermal pad 30 includes an adhesive surface (not shown in the figure). The first thermal pad 30 is stuck to the heating element 10 through the adhesive surface. In this implementation manner, the first thermal pad 30 uses a silicone gel material. The material of the first thermal pad 30 may be adjusted according to an actual need.

Further, the vehicle-mounted wireless Internet access device 100 further includes an antenna (not shown in the figure). The antenna is arranged inside the sealed enclosure 10. The top of the sealed enclosure 10 further includes a non-shielded material part 12. The non-shielded material part 12 corresponds to the antenna, so that signals of the antenna are radiated out.

The sealed enclosure 10 is used to prevent liquids such as water from flowing inside the sealed enclosure 10 to implement a waterproof function. It should be noted that the sealed enclosure may have a gap and an air vent, which is not limited by the present invention. If the sealed enclosure 10 uses a metal material, signals of the antenna cannot be radiated out because the metal material shields the signals of the antenna. Therefore, the sealed enclosure 10 may use a non-shielded material at a corresponding position of the antenna. The non-shielded material is a plastic material. The metal part 11 of the sealed enclosure 10 is designed in a square shape. The top of the sealed enclosure 10 is designed in a square shape. The metal part 11 is located at the center of the sealed enclosure 10.

The non-shielded material may be adjusted according to an actual need. The shape of the metal part of the sealed enclosure 10 may be adjusted according to an actual need, for example, a circle or an oval shape, so long as it is ensured that the top position of the sealed enclosure 10 corresponding to the heating element 10 is a metal part.

The vehicle-mounted wireless Internet access device 100 includes the sealed enclosure 10. The heating element 20 and the first thermal pad 30 are arranged inside the sealed enclosure 10. The top of the sealed enclosure 10 includes the metal part 11. The first thermal pad 30 is arranged between the heating element 20 and the metal part 11 of the sealed enclosure 10 to transfer the heat produced by the heating element 20 to the metal part 11, so that the heating element 20 is cooled. The vehicle-mounted radio network access device 100 does not need to open a cooling port to perform cooling, but transfers, by using the first thermal pad inside the sealed enclosure 10, the heat produced by the heating element 20 to the metal part 11 of the sealed enclosure 10 to implement a cooling function. Therefore, the vehicle-mounted radio network access device 100 in the present invention not only achieves a cooling purpose, but also implements a waterproof function.

Referring to FIG. 3, a vehicle-mounted radio network access device 200 is provided. The vehicle-mounted wireless Internet access device 200 provided in the second implementation manner is similar to the vehicle-mounted radio network access device 100 provided in the first implementation manner, with only a difference in that: In the second implementation manner, the vehicle-mounted radio network access device 200 further includes a heat sink 40. The heat sink 40 is arranged between the first thermal pad 30 and the metal part 11 of the sealed enclosure 10 to absorb the heat transferred by the first thermal pad 30, so that the heat is transferred to the metal part 11 after the heat is dissipated evenly.

Further, an elastomer 42 is arranged on the heat sink 40 to connect the heat sink 40 to the metal part 11 of the sealed enclosure 10, so that the heat on the heat sink 40 is transferred to the metal part 11 through the elastomer 42.

The heat sink 40 and the elastomer 42 use a metal material. The material of the heat sink 40 may be adjusted according to an actual need.

On the vehicle-mounted wireless Internet access device 200 the heat sink 40 is added to evenly dissipate the absorbed heat transferred from the first thermal pad 30 and then transfer the heat to the metal part 11, so that the vehicle-mounted radio network access device 200 has a better cooling effect.

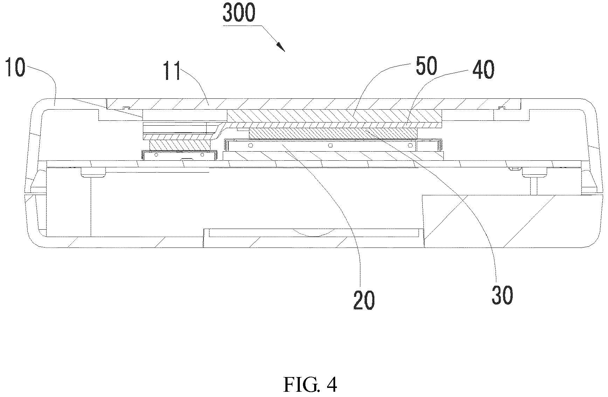

Referring to FIG. 4 an implementation manner of the present invention provides a vehicle-mounted wireless Internet access device 300. The vehicle-mounted radio network access device 300 provided in the third implementation manner is similar to the vehicle-mounted wireless Internet access device 200 provided in the second implementation manner, with only a difference in that: In the third implementation manner, the vehicle-mounted wireless Internet access device 300 further includes a second thermal pad 50. The second thermal pad 50 is arranged between the heat sink 40 and the metal part 11 of the sealed enclosure 10 to transfer the heat on the heat sink 40 to the metal part 11.

Further, the second thermal pad 50 includes an adhesive surface (not shown in the figure). The second thermal pad 50 is stuck to the heat sink 40 through the adhesive surface.

In this implementation manner, the second thermal pad 50 uses a silicone gel material. In other implementation manners, the material of the second thermal pad 50 may be adjusted according to an actual need.

On the vehicle-mounted radio network access device 300 in the present invention, the second thermal pad 50 is added between the heat sink 40 and the metal part 11 of the sealed enclosure 10 to perform secondary cooling, so that the vehicle-mounted radio network access device 300 has a better cooling effect.

## Claims

1. A vehicle-mounted wireless internet access device (100), comprising a sealed enclosure (10), a heating element (20), and a first thermal pad (30), wherein the heating element and the first thermal pad are arranged inside the sealed enclosure; the top of the sealed enclosure comprises a metal part (11), and the first thermal pad is arranged between the heating element and the metal part of the sealed enclosure to transfer heat produced by the heating element to the metal part, so that the heating element is cooled; a heat sink (40), wherein the heat sink is arranged between the first thermal pad and the metal part of the sealed enclosure to absorb the heat transferred by the first thermal pad, so that the heat is transferred to the metal part after the heat is dissipated evenly, and **characterised in** further comprising a second thermal pad (50), wherein the second thermal pad is arranged between the heat sink (40) and the metal part (11) of the sealed enclosure to transfer the heat on the heat sink to the metal part.

2. The vehicle-mounted wireless internet access device (100) according to claim 1, wherein the first thermal pad (30) and the second thermal pad (50) use a silicone gel material and the heat sink uses a metal material.

3. The vehicle-mounted wireless internet access device (100) according to claim 1 or 2, wherein the second thermal pad (50) comprises an adhesive surface and the second thermal pad is stuck to the heat sink through the adhesive surface.

4. The vehicle-mounted wireless internet access device (100) according to any one of claims 1 to 3, wherein the first thermal pad (30) comprises an adhesive surface and the first thermal pad is stuck to the heating element (20) through the adhesive surface.

5. The vehicle-mounted wireless internet access device (100) according to any one of claims 1 to 4, further comprising an antenna, wherein the antenna is arranged inside the sealed enclosure and the top of the sealed enclosure (10) comprises a non-shielded material part, wherein the non-shielded material part corresponds to the antenna, so that signals of the antenna are radiated out.

6. The vehicle-mounted wireless network access device (100) according to claim 5, wherein the non-shielded material part is a plastic material part.

## Patentansprüche

1. Fahrzeugmontierte drahtlose Internet-Zugangsvorrichtung (100), umfassend ein abgedichtetes Gehäuse (10), ein Heizelement (20) und ein erstes thermisches Pad (30), wobei das Heizelement und das erste thermische Pad innerhalb des abgedichteten Gehäuses angeordnet sind, die Oberseite des abgedichteten Gehäuses ein Metallteil (11) umfasst und das erste thermische Pad zwischen dem Heizelement und dem Metallteil des abgedichteten Gehäuses angeordnet ist, um die vom Heizelement erzeugte Wärme auf das Metallteil zu übertragen, so dass das Heizelement gekühlt wird; einen Kühlkörper (40), wobei der Kühlkörper zwischen dem ersten thermischen Pad und dem Metallteil des abgedichteten Gehäuses angeordnet ist, um die vom ersten thermischen Pad übertragene Wärme zu absorbieren, so dass die Wärme auf das Metallteil übertragen wird, nachdem die Wärme gleichmäßig abgeleitet worden ist, und **dadurch gekennzeichnet, dass** sie ferner ein zweites thermisches Pad (50) umfasst, wobei das zweite thermische Pad zwischen dem Kühlkörper (40) und dem Metallteil (11) des abgedichteten Gehäuses angeordnet ist, um die Wärme auf dem Kühlkörper auf das Metallteil zu übertragen.

2. Fahrzeugmontierte drahtlose Internet-Zugangsvorrichtung (100) nach Anspruch 1, wobei das erste thermische Pad (30) und das zweite thermische Pad (50) ein Silikongelmaterial verwenden und der Kühlkörper ein Metallmaterial verwendet.

3. Fahrzeugmontierte drahtlose Internet-Zugangsvorrichtung (100) nach Anspruch 1 oder 2, wobei das zweite thermische Pad (50) eine Klebefläche umfasst und das zweite thermische Pad durch die Klebefläche an den Kühlkörper geklebt ist.

4. Fahrzeugmontierte drahtlose Internet-Zugangsvorrichtung (100) nach einem der Ansprüche 1 bis 3, wobei das erste thermische Pad (30) eine Klebefläche umfasst und das erste thermische Pad durch die Klebefläche an das Heizelement (20) geklebt ist.

5. Fahrzeugmontierte drahtlose Internet-Zugangsvorrichtung (100) nach einem der Ansprüche 1 bis 4, ferner umfassend eine Antenne, wobei die Antenne innerhalb des abgedichteten Gehäuses angeordnet ist und die Oberseite des abgedichteten Gehäuses (10) ein nicht abgeschirmtes Materialteil umfasst, wobei das nicht abgeschirmte Materialteil der Antenne entspricht, so dass Signale der Antenne abgestrahlt werden.

6. Fahrzeugmontierte drahtlose Netzwerk-Zugangsvorrichtung (100) nach Anspruch 5, wobei das nicht abgeschirmte Materialteil ein Kunststoffinaterialteil ist.

## Revendications

1. Dispositif d'accès sans fil à Internet monté sur véhicule (100), comprenant un boîtier scellé (10), un élément chauffant (20) et un premier tampon thermique (30), l'élément chauffant et le premier tampon thermique étant disposés à l'intérieur du boîtier scellé ; le sommet du boîtier scellé comprenant une partie métallique (11), et le premier tampon thermique étant disposé entre l'élément chauffant et la partie métallique du boîtier scellé pour transférer la chaleur produite par l'élément chauffant à la partie métallique, de telle sorte que l'élément chauffant est refroidi ; un dissipateur thermique (40), le dissipateur thermique étant disposé entre le premier tampon thermique et la partie métallique du boîtier scellé pour absorber la chaleur transférée par le premier tampon thermique, de telle sorte que la chaleur est transférée à la partie métallique après que la chaleur s'est dissipée uniformément, et **caractérisé en ce qu'**il comprend en outre un deuxième tampon thermique (50), le deuxième tampon thermique étant disposé entre le dissipateur thermique (40) et la partie métallique (11) du boîtier scellé pour transférer la chaleur sur le dissipateur thermique à la partie métallique.

2. Dispositif d'accès sans fil à Internet monté sur véhicule (100) selon la revendication 1, dans lequel le premier tampon thermique (30) et le deuxième tampon thermique (50) utilisent un matériau en gel de silicone et le dissipateur thermique utilise un matériau métallique.

3. Dispositif d'accès sans fil à Internet monté sur véhicule (100) selon la revendication 1 ou 2, dans lequel le deuxième tampon thermique (50) comprend une surface adhésive et le deuxième tampon thermique est collé au dissipateur thermique par la surface adhésive.

4. Dispositif d'accès sans fil à Internet monté sur véhicule (100) selon l'une quelconque des revendications 1 à 3, dans lequel le premier tampon thermique (30) comprend une surface adhésive et le premier tampon thermique est collé à l'élément chauffant (20) par la surface adhésive.

5. Dispositif d'accès sans fil à Internet monté sur véhicule (100) selon l'une quelconque des revendications 1 à 4, comprenant en outre une antenne, l'antenne étant disposée à l'intérieur du boîtier scellé et le sommet du boîtier scellé (10) comprenant une partie en matériau non blindé, la partie en matériau non blindé correspondant à l'antenne, de telle sorte que les signaux de l'antenne sont émis vers l'extérieur.

6. Dispositif d'accès sans fil à un réseau monté sur véhicule (100) selon la revendication 5, dans lequel la partie en matériau non blindé est une partie en matériau plastique.
